# EUROPEAN PATENT APPLICATION

(11) **EP 2 500 739 A1**
(43) Date of publication of application: **19.09.2012**
(21) Application number: 11158206.0
(22) Date of filing: 15.03.2011
(51) Int. Cl.: G01R 33/345, G01R 33/48

(54) **Transmission line apparatus for travelling wave MRI**

(71) Applicant: Deutsches Krebsforschungszentrum, 69120 Heidelberg (DE); Karlsruher Institut für Technologie, 76131 Karlsruhe (DE)
(72) Inventor: Müller, Marco, 75438 Knittlingen (DE); Umathum, Reiner, 69115 Heidelberg (DE); Alt, Stefan, 69221 Dossenheim (DE); Bock, Michael, 69126 Heidelberg (DE); Werner, Wiesbeck, 75210 Keltern (DE)
(74) Representative: Hörschler, Wolfram Johannes

(57) **Abstract**

A transmission line array (106, 106', 106") for magnetic resonance imaging of an object (100) to be imaged comprising a plurality of transmission line elements (118) is proposed, wherein the plurality of transmission line elements (118) are arranged in a generally cylindrical configuration having an arbitrarily chosen longitudinal (Z) length (108, 112, 124). Furthermore, a method for creating a radio-frequency excitation field for magnetic resonance imaging using a transmission line array (106, 106', 106") comprising transmission line elements (118) in a generally cylindrical configuration is proposed, wherein the method includes the steps:
a) positioning said transmission line array (106, 106', 106") having an arbitrarily chosen longitudinal (Z) length around an object (100) to be imaged or selectively around a section of said object (100) to be imaged,
b) coupling-in a radio-frequency signal to said transmission line array (106, 106', 106"),
c) transmitting and/or receiving travelling radio-frequency waves through said transmission line array (106, 106', 106").

## Description

### FIELD OF THE INVENTION

The invention relates generally to magnetic resonance imaging (MRI) and, more particularly, to a transmission line array for travelling wave MRI as well as a MRI system utilizing the transmission line array to transmit and/or receive travelling radio frequency (RF) waves. The invention further relates to a method for creating a travelling wave RF excitation field for MRI.

### BACKGROUND

A magnetic resonance imaging (MRI) system or a MRI scanner provides a tomographic image indicating physical and chemical characteristics using nuclear magnetic resonance (NMR) generated by irradiating high frequency pulses applied to an object placed in a uniform static magnetic field and is particularly used for medical applications. The MRI system mainly includes a static magnetic field coil device for generating a uniform static magnetic field in an imaging region where the object to be imaged is located, a gradient magnetic field coil device for generating a gradient magnetic field of which magnetic intensity spatially varies in order to encode the spatial coordinates, an radio-frequency (RF) coil for irradiating high frequency pluses to the object to be imaged, a receiving coil for receiving a magnetic resonance signal from the object to be imaged, and a computer system for processing the received magnetic resonance signal to display the tomographic image. In the context of MRI the static magnetic field is usually referred to as B0-fiel and the term (electromagnetic) B1-field is frequently used to refer to the RF fields involved in MRI, particularly the field of the transmitted RF excitation pulses.

The actual nuclear magnetic resonance signal detection is traditionally based on Faraday induction in an RF coil. Often several coils are employed to accelerate the imaging process or to increase the signal to noise ratio. These coils are brought into close proximity to the object to be imaged, thus relying on close coupling between the detector and the object under investigation. Another approach to reduce scan time in magnetic resonance imaging (MRI) considerably, is Sensitivity encoding (SENSE), where spatial information related to the coils of a receiver array are utilized for reducing conventional Fourier encoding (see e.g. Pruessmann et al., Magnetic Resonance in Medicine Vol. 42, p. 952-962, 1999).

One example of an RF coil based on a mircostrip design is described in US 2003/184293. There a multiple channel array coil for MRI is disclosed, which includes a plurality of conductive strips formed within a dielectric medium. The conductive strips are further arranged into a generally cylindrical configuration, with each of the strips having a strip length, selected to cause each of the strips to serve as a resonator at a frequency corresponding to a proton MRI frequency. Thereby, the generally cylindrical configuration of conductive strips forms a multiple channel, volume resonator used to create a quarter wavelength, standing wave resonator or a half wavelength, travelling wave resonator. The resonators disclosed in US 2003/184293 are thus restricted in length in order to allow for optimally decoupling the different channels from each other.

However, for high field applications (> 3Tesla (T)) the creation of a homogeneous RF excitation field is more involved, since the wavelength at the Larmor frequency is substantially smaller than the target volume. This results in a non uniform coverage of the object to be imaged and body parts. This leads to standing wave field patterns, which degrade the MRI results by causing localised signal loss and perturbing the contrast between different types of tissue. In order to avoid these effects Brunner *et al.* proposed a technique based on travelling waves. In the publication "Travelling-wave nuclear magnetic resonance" of David O. Brunner, Nicola De Zanche, Jürg Fröhlich, Jan Paska und Klaas P. Pruessmann, Vol. 457, 19. Februar 2009, doi:10.1038/nature07752 the authors show that NMR can also be excited and detected by long-range interaction, relying on travelling RF waves, sent and received by a patch antenna imaged lower extrimties.

Although the concept of travelling RF waves allows for a uniform coverage of the object to be images, travelling wave interactions also introduces difficulties. One major problem related to travelling waves stems from the fact that the transmit/receive antenna is located far away from the probe and hence the travelling wave has to propagate through the object to be imaged. Thus, when imaging a centre body part, such as the pelvis, thorax or abdomen, the travelling wave penetrates the lower extremities or the head first, which partially absorb RF energy leading to a non uniform B1-field distribution and to SAR loading of the extrimities or the head. Additionally, reflections of the propagating waves when the waves contact the human body, caused by considerable differences in permittivity, result in interferences. Both of these effects cause inhomogeneities in the B1-field distribution and hence degrade the image quality.

Another aspect introducing difficulties in the travelling wave approach concerns the specific absorption rate (SAR), since the RF power or energy deposited in the object to be imaged causes heating of e.g. tissue and has to be limited. The SAR defines the rate at which RF energy is deposited into the object to be imaged and is generally measured in terms of Watts per Kilogram (W/kg). For example, doubling the field strength of the static magnetic field from e.g. 1.5 Tesla (T) to 3 T results in quadrupling of the SAR. Therefore, SAR limits are legally mandated to ensure patient safety. In this context, averaging over the whole body leads to the global SAR. Wave reflections lead to an inhomogeneous B1 field but also to an inhomogeneous electric field distribution. Areas with high electric field energy and/or high electric conductivity lead to high dielectric losses resulting in heating of these areas. This can lead to a local exposure where most of the absorbed electric energy is applied to one body region rather than the entire person, giving rise to the concept of a local SAR. Generally these SAR effects are due to dielectric losses based on the electric field component of the RF field, which in a MRI system is difficult to be predicted or measured. As a result these effects are uncontrollable. Furthermore, owing to the absorption characteristics of travelling waves more RF energy has to be used in order to enable imaging of central body parts. Hence, more RF energy than necessary for the actual imaging process needs to be coupled into the body increasing the local and global SAR.

### OBJECT OF THE INVENTION

It is one object of the invention to provide means for creating travelling wave RF excitation fields applicable particularly to high field MRI and thus avoiding interferences that appear when utilizing standing wave RF excitation fields.

It is another object of the invention to provide means for creating travelling wave RF excitation fields which generate a homogeneous B1-field distribution and minimize the RF exposure of the object to be imaged in contrast to patch antenna approaches. Specifically, the invention aims to reduce the global SAR and the risk of hot spot appearance.

It is a further object of the invention to provide means for transmitting travelling RF waves in order to create travelling wave RF excitation fields and receiving travelling waves from excited nuclei. Additionally, the invention aims to provide means for transmitting and/or receiving travelling RF waves, wherein these means allow for imaging at different frequencies and/or at different magnetic field strengths of a MRI system without hardware modification.

It is yet a further object of the invention to provide means for transmitting and/or receiving travelling RF waves, which are flexible in their use and easy to implement in an MRI system. Furthermore, the invention aims to provide means for transmitting and/or receiving travelling RF waves, wherein these means are adaptable to all sizes of an object to be imaged or a section of an object to be imaged.

### DESCRIPTION

According to the invention a transmission line array for magnetic resonance imaging of an object to be imaged is proposed, which comprises a plurality of transmission line elements arranged in a generally cylindrical configuration having an arbitrarily chosen longitudinal length.

In the sense of the present invention "transmission line elements" refer to individual units which serve to transmit and/or receive travelling RF waves.

The term "generally cylindrical configuration" in the sense of the present invention refers to an assembly of transmission line elements which are arranged such that they enclose an essentially cylindrical shape. In this context "cylindrical" refers to any geometrical structure including a base and a lateral area. In this sense the generally cylindrical configuration of transmission line elements can feature e.g. a circular or an elliptical base shape in the transversal plane. Furthermore, the generally cylindrical configuration includes transmission line elements disposed in regular or irregular intervals on its lateral area. A transmission line array may generally include a variable number of transmission line elements, but at least one transmission line element. Preferably, the transmission line array comprises at least two elements arranged at diametrically opposite points on the lateral area of the cylindrical configuration.

The term "arbitrarily chosen longitudinal length" refers to the length of the generally cylindrical configuration of transmission line elements, where the longitudinal axis coincides with the axial direction of the generally cylindrical configuration. In this context "arbitrarily chosen" longitudinal length refers to any arbitrary axial length of the generally cylindrical configuration. This length, however, does not exceed the length of the MRI system's bore. The MRI system's bore dimension is usually defined by the magnet generating the uniform static magnetic field of strength from 0.5 T up to 11.7 T and more. Such magnets are typically coil- or donut-shaped superconducting magnets.

The proposed transmission line array comprises multiple transmission line elements, which serve to transmit and/or receive travelling RF waves. This way particularly the interference effects appearing in high field MRI with standing wave RF excitation fields can be avoided.

The proposed transmission line array further allows to create travelling wave RF excitation fields which exhibit a homogeneous B1-field distribution resulting in high imaging quality. Additionally, the SAR of the travelling wave RF excitation fields created by the proposed transmission line array may be kept at a minimum.

Owing to the arbitrarily chosen longitudinal length of the proposed transmission line array, the invention offers the potential of locally exposing the object to be imaged or a section of the object to be imaged to traveling wave RF excitation fields to minimize RF exposition in contrast to previous travelling wave approaches with a patch antenna. Hence, the generally cylindrical configuration of individual transmission line elements defines an investigation area, which is exclusively fed by RF energy in the form of travelling RF waves. Thus, the excitation of an RF field occurs locally in the region, where it is needed for imaging and no energy is lost due to absorption or reflection by other body parts. This is particularly apparent when imaging the abdomen or the pelvis of an object to be imaged, since the transmission line array can be placed, where the RF field is needed and only the parts of interest may be exposed to the travelling RF waves. Owing to such local exposure no RF energy is absorbed by other body parts, such as the head, shoulder or lower extremities, and the global SAR remains limited. Also, electromagnetic interferences and the risk of hot spot appearance in high field MRI are decreased, since the RF field excited by the invention is homogeneous at the imaging area and is not disturbed by partly being absorbed by other body parts before it reaches the imaging area as in the case of patch antenna configurations.

Additionally, the proposed transmission line array is easy to produce and assemble, which allows for flexibly adapting the transmission line array to different shapes and/or sizes of an object or a section of an object to be imaged. Thus, the proposed transmission line array can easily be adjusted to different body parts and its geometry allows for a space-saving design. However, the use as a body coil still remains feasible.

In contrast to the prior art, the concept of transmitting and/or receiving travelling RF waves via the proposed transmission line array is based on a broadband radio frequency mode which does not have a cut-off frequency. Thus, no restriction is imposed on the applicability of travelling waves at different radio-frequencies.

Lastly, parallel imaging techniques such as SENSE can easily be transferred to the present transmission line array concept.

In one aspect of the invention, the longitudinal length of the generally cylindrical configuration of transmission line elements depends on the object to be imaged or a section of the object to be imaged. Hence, the transmission line array according to the present invention can either be designed as body coil, which surrounds the object to be imaged, or the transmission line array can be adapted to the object to be imaged or a section of the object to be imaged. Preferably, specific body parts, such as legs, thorax, pelvis or shoulders, are surrounded by the generally cylindrical configuration of transmission line elements. In this design only the section of the object, which is to be imaged, is exposed to travelling RF waves minimizing the global SAR.

In another aspect of the invention, the plurality of transmission line elements are operable to transmit and receive travelling RF waves at variable radio frequencies. In MRI this feature is particularly useful, since images can be taken based on different nuclei such as 1 H, 23 Na, 31 P, 13 C, 3 He, 7 Li, 35 Cl or 17 O. The information from different nuclei can be utilized to create superimposed images without having to move the patient or change the equipment of the MRI scanner. Accordingly, the same transmission line array may be employed at different B0-field strengths as well.

The transmission line elements are capable of transmitting and/or receiving travelling RF waves at variable radio frequencies simultaneously or consecutively. When operating the individual transmission line elements at different frequencies simultaneously or consecutively, multiple signals result from excitation of multiple nuclei mostly simultaneously. In order to differentiate between these different frequencies in a simultaneous or consecutive operation, the detection of magnetic resonance signals from the object to be imaged may be realized by multiplexing methods. Such multiplexing methods are well known in the art and allow for recovering the separate magnetic resonance signals at the receiving end. Such a feature reduces scan time increasing comfort for the patient.

Generally, the transmission line elements can comprise any type of conductor, which carries electromagnetic waves from a one position A to a second position B. In a further aspect of the invention, the transmission line elements comprise at least two electrical conductive strips along a longitudinal direction forming a gap between at least one inner and at least one outer electrical conductive strip. Here the electrical conductive strips are preferably made of a conductive, non-magnetic metal such as copper, gold or silver. The at least two electrical conductive strips along a longitudinal direction forming a gap between the at least two electrical conductive strips serve to guide travelling RF waves coupled into the transmission line elements. This way, travelling RF waves can be extracted of the transmission line elements such that they only penetrate the object to be imaged or section of the object to be imaged. Furthermore, the generally cylindrical configuration of transmission line elements comprising at least two electrical conductive strips allow to generate a homogeneous B1-field distribution in the area, where the object to be imaged or the section of the object to be imaged is placed in order to acquire high quality images.

In a further embodiment of the present invention at least one of the at least two electrical conductive strips exhibits a concave or convex shape along the longitudinal direction and/or at least one of said at least two electrical conductive strips is curved in a concave or convex manner along the longitudinal direction. In this context, convex refers to the curving out with respect to the center of a transmission line element between the at least two electrical conductive strips, opposed to concave, which refers to curving in or hollowed inward with respect to the center of the transmission line element between the at least two electrical conductive strips. In a first alternative, the area of the inner and outer electrical conductive strips exhibits a convex or concave shape. Furthermore, the electrical conductive strips may be curved or formed in a concave or convex manner affecting the shape of the gap enclosed by the inner and outer electrical conductive strip. By shaping the electrical conductive strips in such a way, the B1-field distribution along the longitudinal direction can be tailored to exhibits a plateau along the longitudinal direction of the generally cylindrical configuration. Apart from the shape and arrangement of the electrical conductive strips, the B1-field characteristics produced by the transmission line array may also be altered through other design parameters of the transmission line elements comprising conductive strips and the transmission line array comprising transmission line elements. For instance, the width of the at least one inner and the at least one outer electrical conductive strip or the separation between transmission line elements influences the B1-field distribution.

In a preferred embodiment of the transmission line array according to the present invention a plurality of transmission line elements comprise a dielectric medium in the gap between the at least one inner and at least one outer electrical conductive strip. The dielectric medium preferably comprises acrylic glas or polytetrafluorethylen (PTFE). In this embodiment the dielectric medium concentrates the electric field component of the travelling RF wave between the at least one inner and the at least one outer conductive strip. Thus, the presence of the electric field component can be minimized at the position of the object to be imaged or the section of the object to be imaged. Additionally, the dielectric medium material influences the electromagnetic wave length, which allows to reduce the length of the transmission line array according to the present invention due to the reduced electromagnetic wave length in order to facilitate propagation of mode defined travelling RF waves.

In a further preferred embodiment of the transmission line array according to the present invention at least one end portion of the transmission line elements ist impedance matched by utilizing capacitive and/or inductive elements. Alternatively, impedance matching may be realized by adjusting the gap between the conductive strips. Impedance matching ensures that the impedance of the input source for coupling in the travelling RF wave into the individual transmission line elements is matched to the impedance of the transmission line array comprising a plurality of transmission line elements. By way of impedance matching the power transfer between the input source for travelling RF waves and the transmission line array is maximized and reflections from the transmission line array are minimized.

In a further embodiment of the present invention at least one other end of the transmission line elements can be electrically terminated in order to dump the RF energy coupled into the transmission line elements. The termination can be achieved via a high load resistor which transforms the RF energy into heat. An alternative embodiment of the transmission line array according to the present invention includes a feedback circuit, where the RF energy is fed back from the out coupling end of the transmission line elements to the in coupling end of the transmission line elements. In this case the RF energy fed back to the in coupling end is added on top of the RF energy supplied by the signal source. Further means for modifying the phase and the amplitude of the input and fed back RF energy may be employed.

In a further embodiment of the transmission line array according to the present invention a radio-frequency signal coupled into adjacent transmission line elements exhibits a phase shift. The phase shift between adjacent transmission line elements can be between 0 ° and 180°. In a preferred embodiment the phase shift between neighboring transmission line elements is selected such that the whole transmission line array comprising the transmission line elements exhibits a circular polarization. For, say 16 transmission line elements making up the generally cylindrical configuration, the phase shift between adjacent elements amounts to 22.5°. This is equivalent to a phase shift of 180° between opposite transmission line elements. In this preferred embodiment exhibiting circular polarization, the B1-field distribution decreases from the edges of the generally cylindrical configuration and exhibits a local maximum around the center of the generally cylindrical configuration. Furthermore, the electric field component exhibits a minimum in the center of the generally cylindrical configuration, which significantly reduces the occurrence of hot spots. In another embodiment the phases may be balanced between neighboring transmission line elements, i.e. no phase shift. Balanced phases result in a B1-field distribution that exhibits a minimum at the center of the generally cylindrical configuration. Thus, the combination of alternating phases such that e.g. every second transmission line element exhibits a phase shift resulting in a circularly polarized arrangement of the transmission line array allows for regulating the B1-field distribution around the center of the generally cylindrical configuration. This way, the homogeneity of B1-field distribution can be adjusted, such that it exhibits a plateau in the area, where the object to be imaged or a section of the object to be imaged is placed.

Apart from the phase shift between neighboring transmission line elements, the amplitude of the radio-frequency signal coupled into the transmission line elements can be modulated. With a variable phase and amplitude of the radio-frequency signal coupled into the transmission line elements of the transmission line array, the signal source allows for flexibly adjusting these variables to create an intended field distribution in the object to be imaged or in the section of the object to be imaged. Furthermore, approaches such as SENSE and particularly transmit SENSE become feasible in such an arrangement transmitting travelling RF waves, where each channel includes an independent transmitter. In another embodiment of the present invention the generally cylindrical configuration of transmission line elements is partially or fully surrounded by an RF shield. The shielding can be designed as a separate shield surrounding the plurality of transmission line elements. This shield can either cover the outer conductive strips of the transmission line elements in a generally cylindrical configuration solely along the longitudinal axis or also comprise a transversal section at the edges of the generally cylindrical configuration. A section at the edges is advantageous in that respect, that without this section the RF field can escape at the edges of the cylindrical configuration leading to unwanted additional RF exposure of the object to be imaged outside the imaging region. Furthermore, the RF shield itself can either be closed or open while surrounding the plurality of transmission line elements. In this context, closed refers to a shield made of one piece whereas open refers to a RF shield that is segmented into two or more parts. For example, in an arrangement, where at least two transmission line elements are located at diametrically opposite points of an object to be imaged, the shield may cover each of the transmission line elements on both sides of the object to be imaged. In such a case the shield preferably reaches as far as the object to be imaged. Of course, such an embodiment may include a plurality of transmission line elements in one or more segmented shields.

In an alternative embodiment, the shielding effect can be accomplished by using electrical conductive tape on the outer conductive strips in order to form a shielding in the spaces between adjacent transmission line elements. The tape can be connected to the outer electrical conductive strips by a galvanically decoupled connection. Each of the proposed RF shields is preferably made of an electrical conductive, non-magnetic material which shields the transmission line elements from electromagnetic coupling with external conductive elements leading to impedance mismatch and to electromagnetic interferences and at the same time focuses the travelling RF waves inside the transmission line array.

The present invention further concerns a magnetic resonance imaging system for imaging an object, which comprises a magnet assembly for generating a uniform magnetic field, a gradient coil assembly for applying gradient magnetic fields to said uniform field along selected gradient axes as well as means for applying travelling radio-frequency waves to excite nuclear spins of an object to be imaged and thereafter detecting signals generated by excited nuclei of said object to be imaged, wherein said means for transmitting and receiving travelling radio-frequency waves comprise the transmission line array described above.

A MRI scanner utilizing the transmission line array described above has the advantage of providing a high imaging quality combined with a low SAR and a considerably decreased risk of hot spots, especially of unpredictable hot spots. Owing to the local selectivity provided by the transmission line array, the RF exposure of the object to be imaged is further reduced. Furthermore, the fact that different images can be recorded at different frequencies without having to change the system or relocate the patient offer a high degree of flexibility in the measurement. This feature providing intrinsic co-registration of images is particularly important in situations where more than one type of tissue is of interest. In such situation the different frequencies excite different nuclei and the two images can be compared directly. Such a feature is of major interest for applications, where the cell activity is important as for instance in chemotherapy, where a distinction between responder and non-responder cells is vital. Additionally, in a MRI system according to the present invention different B0-field strengths may be employed without having to modify the system.

The present invention further concerns a method for creating a radio-frequency excitation field for magnetic resonance imaging using a transmission line array comprising transmission line elements in a generally cylindrical configuration, wherein the method includes the steps of:
a) positioning the transmission line array having a arbitrarily chosen longitudinal length around an object to be imaged or a section of an object to be imaged,
b) coupling in of travelling-waves to said transmission line array,
c) transmitting travelling-waves at different radio-frequencies through the transmission line array.

The method of positioning the transmission line array having a arbitrarily chosen longitudinal length around an object to be imaged or a section of an object to be imaged has the advantage, that travelling RF waves can be applied locally to different parts of the object to be imaged minimizing the global SAR while yielding high imaging quality.

The transmission line array utilized in the method according to the present invention preferably exhibits the features described above.

In one embodiment of the present invention, the longitudinal length of the transmission line array is adapted to the object to be imaged or the section of the object to be imaged. In another embodiment of the present invention the transmission line array is positioned locally around a section of the object to be imaged, which remarkably reduces the global SAR.

In a further embodiment of the present invention the travelling-waves are transmitted and/or received at variable radio-frequencies. Thus, the method offers to couple different frequencies into the transmission line array, which are transmitted as travelling waves at different frequencies. This allows for a high flexibility in the imaging method, since different frequencies are accessible to the imaging method.

In another embodiment of the invention the transmission line array is connected to a transceiver circuit for transmitting and/or receiving travelling radio-frequency waves, wherein said transceiver circuit controls a plurality of transmission line elements of the transmission line array individually. The transceiver circuit can further comprise a plurality of phase shifters, adjusting the phase of the travelling radio-frequency waves coupled into the transmission line elements, and means to adjust the amplitude of said travelling radio-frequency waves coupled into the transmission line elements. Generally, the phase shifters and/or means to adjust the amplitude can control transmission line elements individually for each channel. Beside design issues of the transmission line array, this gives the flexibility to tailor the B1-field and electric field distribution in the region of the object to be imaged.

In another embodiment of the invention the transceiver circuit includes at least one source/receiver, at least one impedance matching network and at least one transmit receive switch. The radio-frequency wave is preferably coupled into said transmission line array at an input end of said transmission line array and coupled out at an output end of said transmission line array, wherein the travelling radio-frequency waves are dissipated at a dissipating termination or said travelling radio-frequency waves are fed back to the input end by a feedback circuit. A feedback circuit allows for energy regeneration and thus provides a way to operate the transmission line array more efficiently.

### BRIEF DESCRIPTION OF THE DRAWINGS

The subject matter of the invention will be explained in more detail in the following with reference to preferred exemplary embodiments, which are illustrated in the attached drawings, which show
- Figure 1: a principle cross sectional view of an MRI system with an object to be imaged surrounded by transmission line arrays according to the present invention in exemplary positions as seen from the top;
- Figure 2: the MRI system of Figure 1 including transmission line arrays in exemplary positions in a side view;
- Figure 3: a cross sectional view of one embodiment of a transmission line array according to the present invention;
- Figure 4: a front view of the embodiment according to Figure 3;
- Figure 5: a cross sectional view of an alternative embodiment of a transmission line array according to the present invention;
- Figure 6: a front view of the embodiment according to Figure 5;
- Figure 7: a schematic of the typical B1-field distribution as generated by a transmission line array according to the present invention in the longitudinal plane;
- Figure 8: a schematic of the typical B1-field distribution according to Figure 7 in the transversal plane;
- Figure 9: a schematic longitudinal central cut through a typical B1-field distribution as generated by the transmission line array;
- Figure 10: a schematic central cut along an axis in the transversal plane through a typical B1-field distribution as generated by the transmission line array;
- Figure 11: a schematic longitudinal central cut through a typical SAR distribution as generated by the transmission line array;
- Figure 12: a schematic central cut along an axis in the transversal plane through a typical SAR distribution as generated by the transmission line array;
- Figure 13: a schematic view illustrating an embodiment of opposite transmission line array elements making up the transmission line array;
- Figure 14: shows a schematic longitudinal, central cut through a typical B1-field distribution generated by array elements illustrated in Figure 13;
- Figure 15: shows a schematic view illustrating an alternative embodiment of opposite transmission line array elements exhibiting a concave shape in upside view;
- Figure 16: a schematic longitudinal central cut through a typical B1-field distribution generated by array elements illustrated in Figur 15;
- Figure 17: a schematic view illustrating an embodiment of opposite transmission line array elements formed in a convex shape;
- Figure 18: a schematic view illustrating a further embodiment of opposite transmission line array elements formed in a convex/concave shape;
- Figure 19: a transceiver circuit for coupling in travelling radio frequency waves including a dissipating termination end;
- Figure 20: another embodiment of a transceiver circuit for transmitting and receiving travelling radio frequency waves;
- Figure 21: a illustrative view of a transmit part of a transceiver circuit including a feedback circuit;
- Figure 22: a embodiment of a transmit part of a transceiver circuit including a feedback circuit;
- Figure 23: another embodiment of a transmit part of a transceiver circuit including a feedback circuit;

### PREFERRED EMBODIMENTS

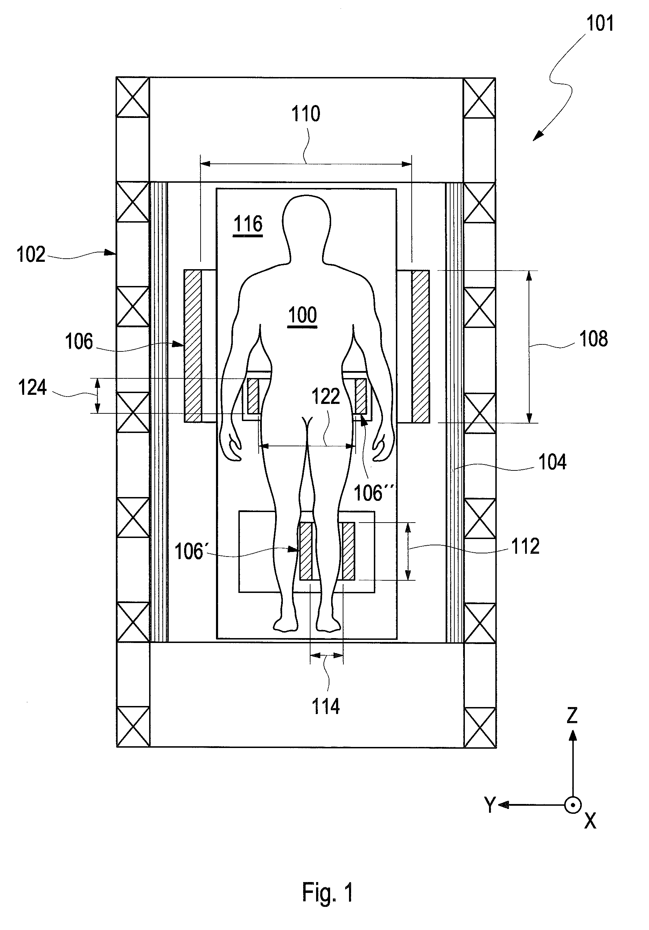

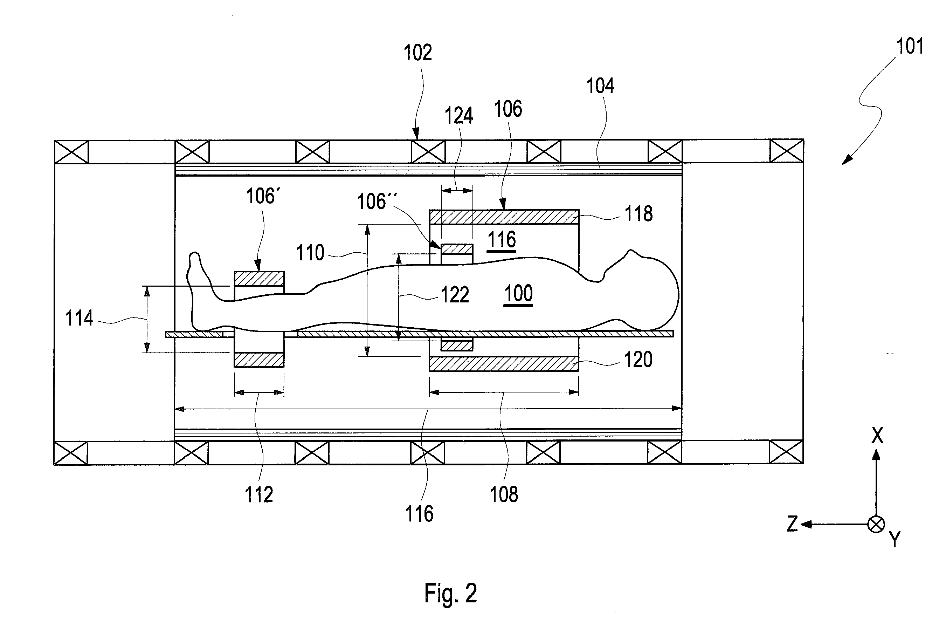

Figure 1 shows a top view cut through an MRI system or MRI scanner 101 including means to generate the uniform static magnetic field 102. In the context of MRI systems 101 the long axis of the system is usually referred to as the longitudinal dimension Z, which also defines the axis of the static magnetic field. The plane perpendicular to the longitudinal axis is referred to as the transversal plane including due to symmetry equivalent X- and Y-axis. Apart from the strong uniform static field usually produced by superconducting magnets, further gradient field coils 104 apply a gradient to the investigation area 116 and aid to encode positional information. For the sake of clarity further details of a MRI system are omitted in figures 1 and 2.

In an MRI system such as the one shown in figure 1, the object 100 to be imaged is usually placed on a slide which is moved into the bore of the magnet 102. The magnet 102 can either exhibit a coil-like shape forming a closed bore or a donut-like design forming an open bore. In order to produce locally the RF excitation field, the transmission line array 106, 106', 106" according to the present invention is positioned around the object 100 to be imaged. The transmission line arrays 106, 106', 106" shown in figure 1 comprise a plurality of transmission line elements 118, which are arranged in a cylindrical configuration around the object 100 or a section of the object 100 to be imaged.

Figure 1 demonstrates overall three possibilities for placing the transmission line array 106, 106', 106". The larger embodiment of the transmission line array 106 is located around the upper part of the body including pelvis, abdomen and thorax. This embodiment 106 exhibits a larger diameter 110 and longitudinal (Z) length 108 than the alternative embodiment 106' surrounding part of the leg or the further embodiment of a transmission line array 106" surrounding the abdomen. In this case the leg transmission line array 106' has a diameter 114 and length 112, which is adapted to fit to the part of the leg being imaged. If only the abdomen is to be imaged, the transmission line array 106" is adjusted to the size of the region of interest featuring a diameter 122 and a longitudinal length 124, which is adapted to fit to the abdomen. By way of example Figure 1a shows, how the transmission line array 106, 106', 106" can be employed to generate an RF field selectively at different body parts. This particularly illustrates, that the dimensions of the transmission line array 106, 106', 106" can be adapted to all sizes in length and diameter to cover e.g. the whole body or only parts such as the abdomen array 106 " or the leg array 106'.

Figure 2 depicts the assembly of figure 1 in a side view and again shows a transmission line array 106 for the upper part of the body with a larger diameter 110 and longitudinal (Z) length 108 than the diameter 114 and longitudinal (Z) length 112 of the leg transmission line array 106' or the abdomen transmission line array 106". In a preferred embodiment the transmission line array 106, 106', 106" exhibits a flexible design, which allows tailoring the transmission line array 106, 106', 106" to different applications or objects 100 or sections of objects 100 to be imaged. Such a flexible design can for instance be achieved by building up the transmission line array 106, 106', 106" from individual array elements 118, which are held together by non-magnetic flexible parts such as rubber fillers. This way the array elements 118 can be displaced by bending the flexible parts in between. An alternative arrangement to accomplish such a flexible design is to use some type of plug connection system, which simply allows connecting the individual array elements 118 to adapt different sizes. In another embodiment, the transmission line array 106, 106', 106' may even allow to realise a flexible design for the longitudinal Z length 108, 112, 124 of the cylindrical configuration. In this case, a type of slide or plug connection system in the longitudinal axis of the transmission line elements 118 can be used to flexible adjust the length Z of the transmission line array 106, 106', 106' in the longitudinal axis Z to the object 100 or the section of the object 100 to be imaged.

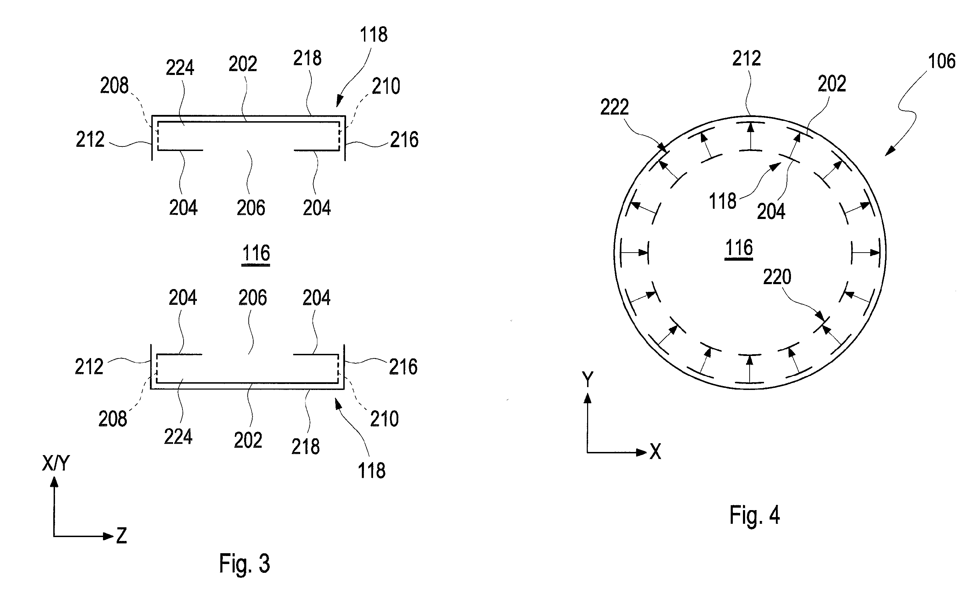

Figure 3 and 4 depict one possible arrangement for transmission line elements 118 making up a transmission line array 106, 106', 106" in cross sectional views. Such transmission line elements 118 generally comprise an outer electrically conductive strip 202 as well as an inner electrically conductive strip 204 in order to guide travelling radiofrequency waves, which present electromagnetic waves.

In the embodiment of figure 3 one transmission line element 118 is built up by electrically conductive strips 202, 204 along the longitudinal (Z) direction. Here the outer electrically conductive strip 202 is continuous and the inner electrically conductive strip 204 is intermitted at the center 206. In this configuration the intermitted inner electrically conductive strip 204 preferably defines the ground plane of the transmission line element 118. As can be seen in the front view of figure 4 the outer electrically conductive strips 202 are arranged in cylindrical configuration forming an outer ring 222. Similarly, the inner electrically conductive strips 204 are arranged in cylindrical configuration forming an inner ring 220. The gap 224 between the two rings 222, 220 and the width of the inner electrically conductive stripes 204 influence the B1-field distribution and can be chosen to allow for a space-saving design of the transmission line array 106, 106', 106" while still achieving a homogenous B1-field distribution in the region of the object 100 or a section of the object 100 to be imaged.

Each end portion 208, 210 of the outer 202 and the inner 204 electrically conductive strip are further connected to impedance matched ports. When transmitting travelling radio frequency waves one of the impedance matched ports 208, 210 is used for coupling in travelling RF waves from generating means. The other port is used as electrical termination by e.g. an energy dissipating resistor or the travelling RF waves are fed back to the input port. Furthermore, the sources generating the travelling RF waves to be coupled into opposite transmission line elements 118 can be 180° out of phase. In the exemplary arrangement of Figure 4, the transmission line array 106, 106', 106" comprises of a total of 16 transmission line elements 118 and the phase difference between adjacent elements amounts to 22.5°. Thus this phase shift produces a circular polarization of the transmission line array 106, 106', 106" and affects the homogeneity of the B1-filed distribution as well as a reduced SAR. The phase shift between opposite transmission line elements 118 can be chosen to be any shift between 0 and 180°.

A phase shift of 180° between opposite transmission line elements 118 produces a B1-filed distribution, which has a local maximum at the center between opposite transmission line elements 118, whereas a phase shift of 0° between opposite transmission line elements 118 produces a B1-filed distribution, which is minimal at the center between opposite transmission line elements 118. Thus, the phase shifts between opposite transmission line elements 118 can also be adjusted in order to achieve a homogeneous B1-field distribution in the area where the object 100 or section of the object 100 to be imaged is located.

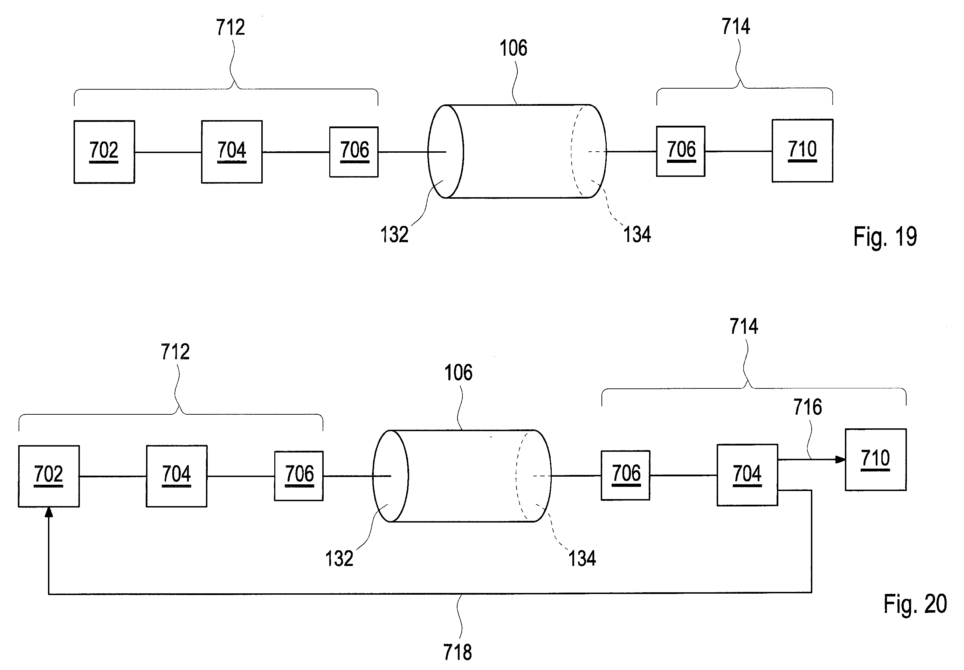

The transmission line elements 118 are additionally capable of receiving signals from the object to be imaged after excitation of the nuclei by the transmitted travelling RF waves. Such a dual mode of transmitting and/or receiving signals is realized by utilizing at least one transmit/receive switch 704 for switching between the two modes and means for generating and receiving 702 such signals. Details regarding the circuitry to operate the transmission line array 106, 106', 106" according to the present invention in transmitting and/or receiving mode will be explained in more detail in the context of figures 19 to 21. For focusing of the RF field inside the transmission line array 106, 106', 106" and to avoid interferences with electromagnetic fields from the outside an additional RF shield 212 surrounds the transmission line array 106. This shield 212 is made of some electrically conductive, non-magnetic material such as copper and covers the full longitudinal length 218 and preferably the edges 216 of the transmission line array 106, 106 106".

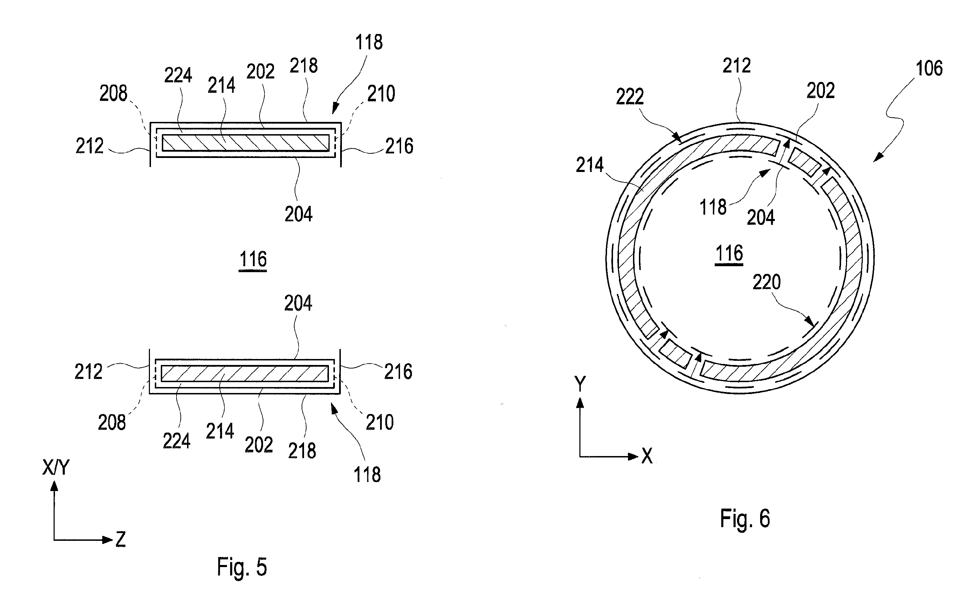

In an alternative embodiment as depicted in Figure 5, a transmission line element 118 is built up by a continuous electrically conductive outer strip 202 and a continuous electrically conductive inner strip 204. In contrast to the embodiment explained above, in this configuration the outer strip 202 preferably defines the ground plane of the transmission line element 118. Furthermore, the RF field is focused inside the transmission line array 106 via an additional RF shield 212 as described above.

Similar to the previous embodiment, each end portion 208, 210 of the outer 202 and the inner 204 electrically conductive strip are connected to impedance matched ports. In transmitting mode one port is used for coupling in travelling RF waves and the other port is used as electrical termination by e.g. an energy dissipating resistor or the travelling RF waves are fed back to the coupling in port. Again the means generating the travelling RF waves to be coupled into opposite transmission line element 118 produce a phase shift, which influences the B1-filed distribution as discussed above. Of course the transmission line array is additionally capable of receiving signals from the object to be imaged after excitation of the nuclei by the transmitted travelling RF waves. However, the circuitry to operate the transmission line array 106, 106', 106" according to the present invention in transmitting and/or receiving mode will be explained in more detail in the context of figures 19 to 21.

As illustrated in the front view of figure 6 and similar to the previously explained embodiment, the outer 202 and inner strips 204 are arranged in cylindrical configuration forming an inner and an outer ring 220, 222. A dielectric medium 214 such as acrylic glas or PTFE can be introduced in the gap 224 between these two rings. It should be noted, that the dielectric medium in figure 6 is preferably introduced as a closed ring. However, alternatively the dielectric medium can be allocated to individual transmission line arrays 118. The dielectric medium 214 in the gap 224 between inner and outer ring 220, 222 further concentrates the electrical field between the strips 202, 204. As dielectric medium 214 acrylic glass (with a relative permittivity of 2.6 Fm⁻¹ at a frequency of 297 MHz) is preferably used. For clarity reasons the dielectric medium 214 in figure 6 is broken inside some of the array elements in order to illustrate the phase shift between opposite elements. The exemplary arrangement shown in figure 6 comprises a total of 16 transmission line elements 118 resulting in a phase difference between adjacent elements of 22.5°; this again results in a circularly polarized transmission line array 106, 106', 106" as indicated by the arrows in figure 6. However, this is only one possibility for the polarization. As described above, the phase shifts between opposite transmission line elements 118 can also be adjusted in order to achieve a homogeneous B1-field distribution in the area, where the object 100 or section of the object 100 to be imaged is located.

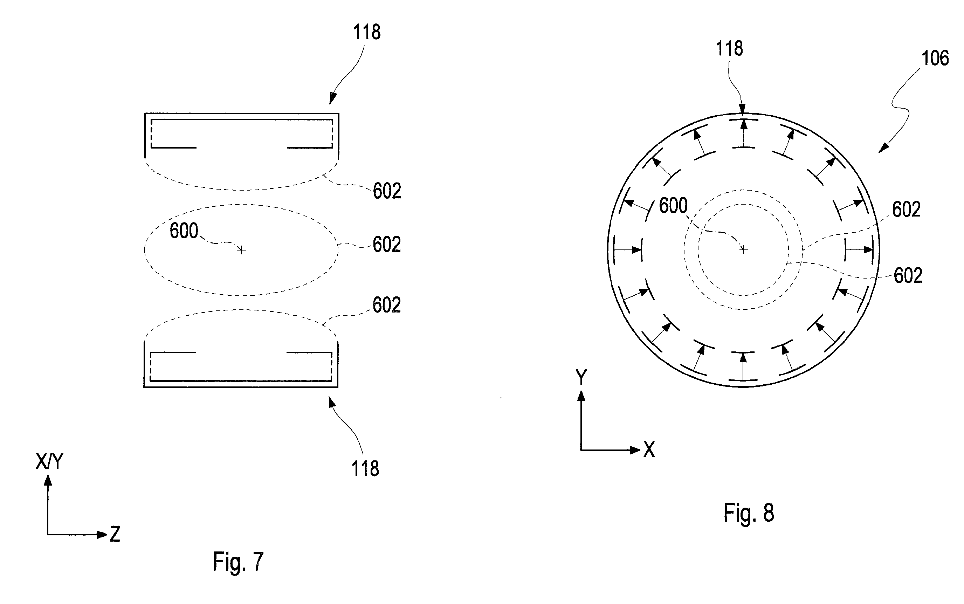

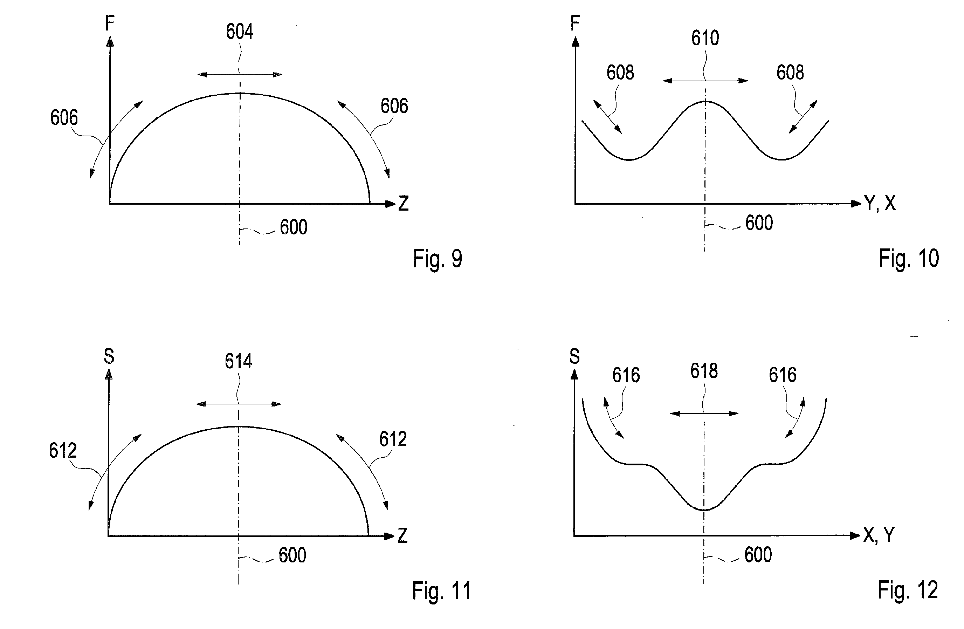

Figures 7 and 8 illustrate the B1-field distribution of the transmission line array 106 arrangements described above. These distributions are illustrated in the longitudinal and the transversal plane through a phantom center 600 by circularly polarized excitation. Here, figure 7 depicts a two dimensional cut including the longitudinal Z direction and figure 8 shows the corresponding cut in a transversal plane X/Y. In both figures dashed equipotential lines 602 illustrate the distribution of the B1-field. Further it should be noted, that the center 600 depicted in figures 7 and 8 coincides with the center of the transmission line array 106, 106', 106" longitudinally Z as well as transversally X/Y. It is instructive at this point to consider Figure 9 illustrating a longitudinal Z center cut through the two dimensional B1-field distribution F shown in Figure 7 as well as Figure 10 illustrating a center cut along a transversal axis X/Y through the two dimensional B1-field distribution F shown in Figure 8.

As can be seen in Figure 9, in the longitudinal direction Z the B1-field distribution F features a stretched high 604 around the center 600 between the two opposite array elements 118, followed by a decrease 606 towards the edges 132, 134 of the transmission line array 106, 106', 106". This longitudinal cut through the B1-field distribution F illustrates a relatively flat area around the center 604 of the distribution, which can be achieved using transmission line array 106, 106', 106" according to the present invention. In the transversal orientation X/Y of figure 10 the B1-field distribution F decreases 608 from the edges towards the center and has a local maximum 610 around the central axis 600, which is caused by constructive interference of the B1-field vectors emerging from opposite transmission line elements 118. Thus, the embodiments of transmission line arrays 106, 106', 106" according to the present invention produce a homogeneous field distribution F in longitudinal Z orientation. This feature of the B1-field distribution F is influenced by various design aspects of the transmission line array 106, 106', 106" as described below and above. The main advantage in creating a homogenous B1-field distribution lies in the fact, that it allows for high imaging quality and at the same time avoids further complications due to the electric field component of the RF field.

Figures 11 and 12 show the corresponding SAR distributions illustrating a longitudinal Z as well as transversal X/Y cut, respectively. As can be seen in Figure 11, the SAR is nearly constant 614 until it rapidly declines 612 outside the transmission line array 106 and thus the object to be imaged 100 is only marginal exposed to a travelling wave RF field outside the transmission line array 106. As illustrated in figure 12, the SAR characteristic in a transversal direction X/Y features a decay 616 towards the center 600 and exhibits a local minimum 618 at the center 600. Depending on the design of the transmission line array 106, 106', 106" the SAR distribution may exhibit an absolute minimum 618 at the center 600 as indicated by the dashed line. The distribution of the SAR and the B1-field as shown herein aid illustration purposes and include general features of distributions measured. The details of the distributions shape, however, depend on the design of the transmission line array 106, 106', 106" (such as separation between adjacent transmission elements 118, width of inner and outer conductive strips 204, 202 or the number of transmission elements 118), the phase shifts of the transmission line elements 118 with respect to each other, the amplitude of the transmission line elements 118 and hence the shape of the distributions can deviate from the ones illustrated.

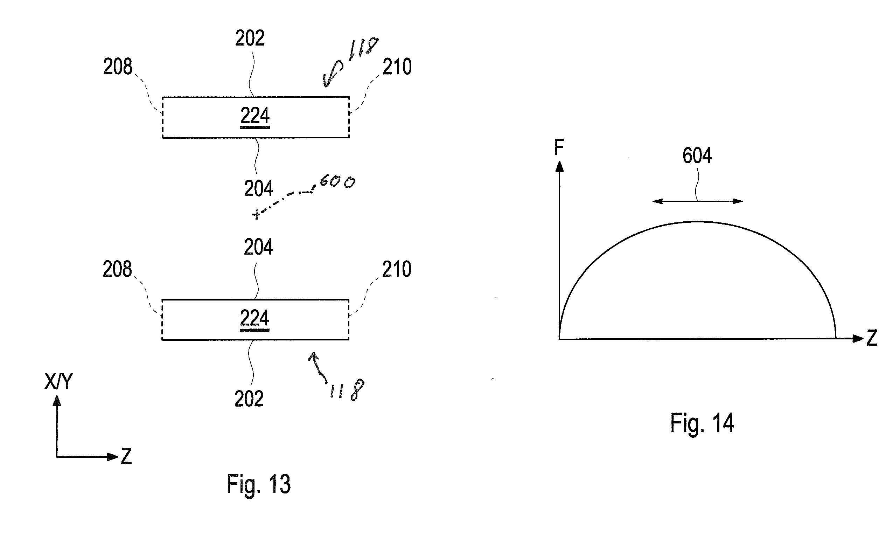

Figures 13 and 14 illustrate the B1-field distribution in the longitudinal direction for a strictly parallel design of the transmission line elements 118 composed of electrical conductive strips 202, 204 arranged in parallel. Here the edges enclosing the area of the electrical conductive strips 202, 204 themselves are parallel. In other words the electrical conductive strips 202, 204 exhibit a rectangular-type of shape seen from the top. The parallel arrangement of the electrical conductive strips 202 and 204 leads to the B1-field distribution exemplary shown in figure 14, which exhibits a nearly flat center portion 604 along the longitudinal Z direction around the center 600.

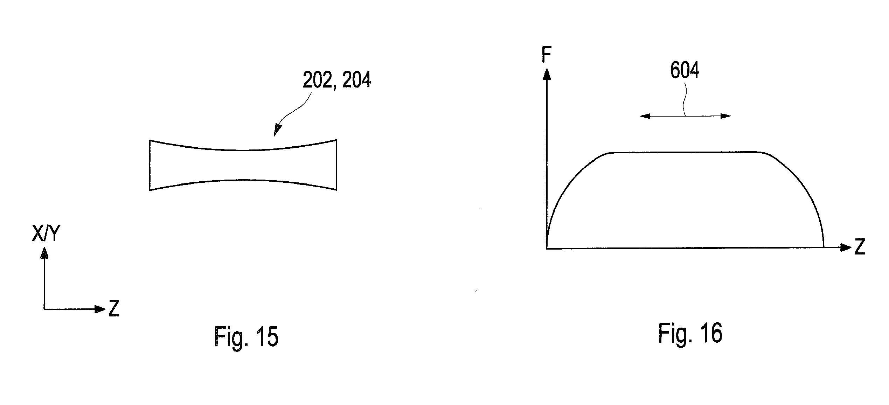

Figures 15 shows an alternative embodiment of the transmission line elements 118, where the conductive strips exhibit a concave shape. In figure 15 one transmission line element 118 is depicted in top view, such that the shape of the conductive strip is seen from the top. Here, the area of the conductive strips 202, 204 themselves exhibit a concave shape and hence, in the cylindrical configuration, the concave shape lies in the plane of the lateral area of the cylindrical configuration. This shape of the conductive strips 202, 204 utilized in the cylindrical configuration leads to a modified current distribution, which produces a B1-field distribution F with a flat plateau 604 in longitudinal Z orientation around the center 600 as shown in figure 16. This is advantageous for imaging quality and resolution of the MRI system. Thus, the shape the conduction strips 202, 204 gives another handle to tailor a B1-field distribution appropriate for MRI applications

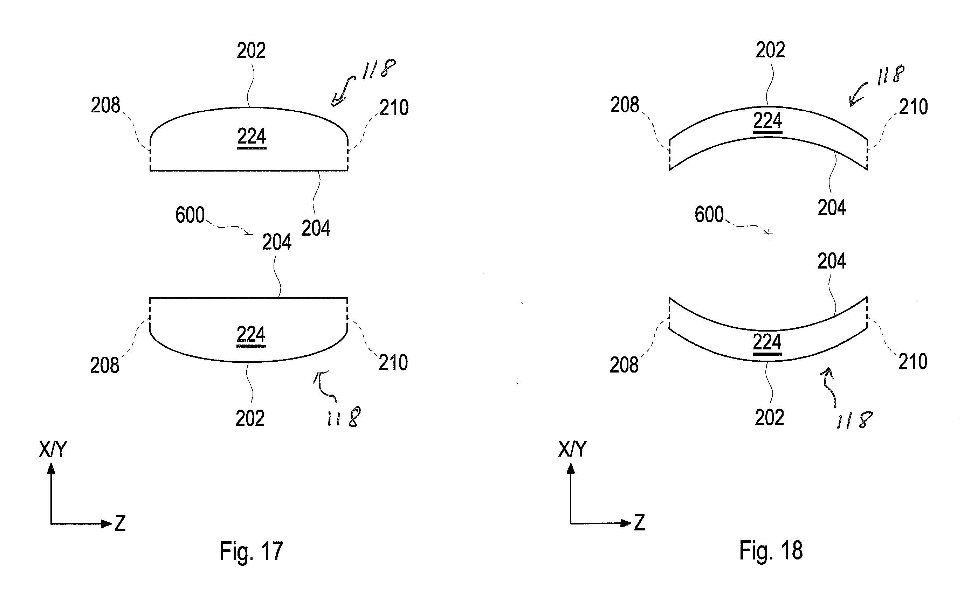

Figures 17 and 18 show further embodiments of the transmission line elements 118, where the electrical conductive strips 202, 204 are curved in a concave or convex shape. In contrast to figure 15, figures 17 and 18 depict transmission line elements 118 which include conductive strips 202, 204 that are arranged in a concave or convex shape thus influencing the shape of the gap 224 the strips 202, 204 enclose. The shape of the actual conductive strips 202, 204 themselves can exhibit a concave shape as illustrated in figure 15. In the embodiment of figure 17 the inner electrically conductive strip 204 remains essentially straight, whereas the outer electrical conductive strip 202 is arranged in a convex shape along the longitudinal Z direction of the generally cylindrical configuration 106. In a design of the transmission line elements 118 as shown in figure 17, the B1-field distribution is influenced as described before. Hence, in comparison to the straight version, the convex shape of the outer electrical conductive strip 202 reduces the B1-field strength at the center 600 and thus produces a plateau in the distribution.

Figure 18 shows a similar design of the inner and outer electrical conductive strips 202 and 204 as shown in Figure 17; however, there the inner electrical conductive strip 204 is arranged in a concave shape. Thus, in the embodiment as shown in Figure 18 both electrical conductive strips 202, 204 exhibit curved belly-like shapes. This design concept allows to modify the homogeneity of the B1-field distribution in the longitudinal direction Z such that the distribution features a plateau along the longitudinal length (108, 112, 124) of the transmission line array 118.

Further design parameters in order to increase the homogeneity of the B1-field distribution are the distance between neighboring transmission line elements 118, the distance between the inner and the outer electrical conductive strips 202, 204 of one transmission line element 118 as well as the width of the inner and the outer electrical conductive strips 202, 204. It is to be understood that a person skilled in the art adjusts these parameters according to the needs of specific embodiments.

Figures 19 to 23 illustrate methods for transmitting and/or receiving travelling RF waves through the transmission line array 106, 106', 106" according to the present invention. However, the purpose of figures 19 to 23 is to illustrate the working principle of the transceiver circuit operating a transmission line array 106, 106', 106". Hereby, the transceiver circuit may be configured to allow either for one common system operating the transmission line elements 118 of the transmission line array 106, 106', 106 " or individual transmission line elements 118 may operated individually. Thus, the embodiments shown in figures 19 to 23 should not be understood to constrain the scope of the present invention.

Generally, the transceiver circuit includes transmit and receive circuits in order to transmit and receive traveling RF waves. Specifically, the transceiver circuit comprises at least one source generating travelling waves such as a signal generator 702, at least one transmit receive switch 704 and impedance matching networks 706 at each end 132, 134 of the transmission line array 106. A signal generator 702 serves to generate the radio-frequencies signal to be coupled into the transmission line array. Furthermore, the signal generator 702 serves as receiver whereas a switch 704 allows to switch between transmit and receive mode. The coupling into a transmission line array 106, 106', 106" or the individual transmission line elements 118 is accomplished via an impedance matching network 706. These components are located at the coupling-in end 712 allowing to couple travelling radiofrequency waves into the transmission line array 106, 106', 106" or transmission line elements 118. At the coupling-out end 714 the RF energy supplied to the transmission line array 106, 106', 106" or element 118 is coupled out via an impedance matching network 706 and dumped in a termination 710. This termination 710 is preferably composed of a resistor that transfers the RF energy into heat.

In contrast to figure 19, figure 20 illustrates a transceiver circuit, where both the coupling-in end 132 as well as the coupling-out end 134 serve to transmit and receive travelling radio-waves. In this embodiment the source/receiver 702 is followed by a transmit receive switch 704 and an impedance matching network 706 at the input end 132 of the transmission line array 106. The output end 134 again comprises an impedance matching network 706 and a switch 704 which in the transmit case 716 is followed by a termination 710. In the receive case the signal is carried through from the switch 704 to the receiver 702. Such an embodiment allows to achieve a better signal to noise ratio.

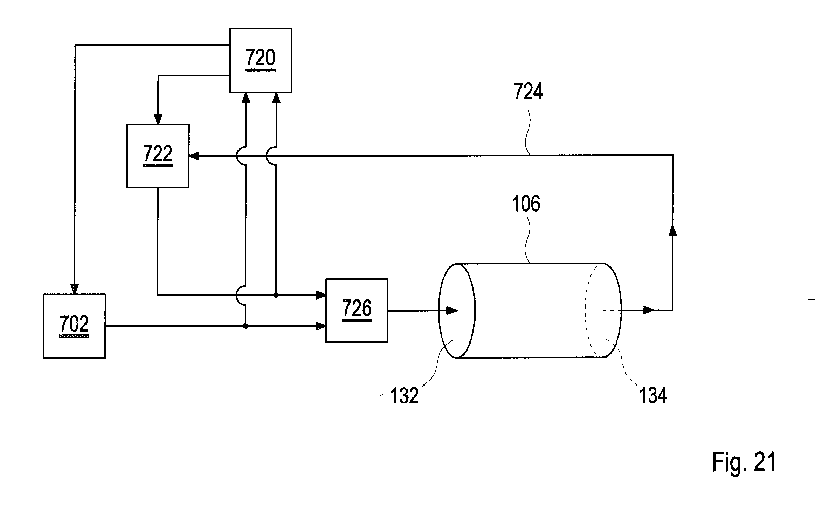

Figure 21 shows yet another embodiment of the transmission part of the transceiver circuit and illustrates the principle concept of regenerating RF energy when operating the transmission line array. In Figure 21 additionally to the RF energy fed into the transmission line array 106 from a signal generator 702, the transmit circuit includes a feedback circuit 724. In this embodiment the input RF energy from the signal generator is coupled into the transmission line array 106 via an impedance matching network 706 (not shown). The output RF energy coupled out at the output end 134 of the transmission line array 106 is fed back into a summing unit 726 located at the input end 132, where the signals are combined. Furthermore, means to detect 720 and adjust 722 the amplitude and phase of the output RF energy are integrated in the simplest version of a feedback circuit. This allows to match the amplitude and phase of the output RF signal and the input RF signal stemming from the signal source 702. The output and input signals are combined at the summing unit 726 and hence, the output RF energy is reused by feeding it back into the transmission line array 106. Furthermore, the amplitude information detected by 720 may be transferred to the signal source 702.

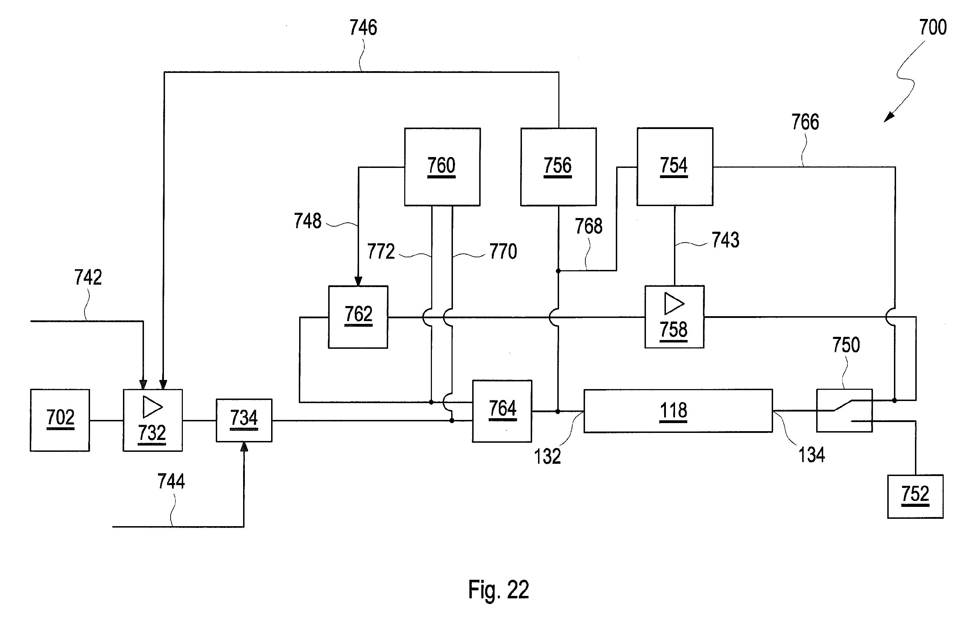

Figure 22 illustrates a further embodiment of transmission circuitry for a transmission line element 106 including a feedback circuit to regenerate RF energy. The input RF signal is generated by a signal generator 702. The input RF signal is further adjustable by means for modifying the amplitude 732 and phase 734 of the input RF signal. An amplifier 732 allows for modifying the amplitude of the input RF signal generated by the signal generator 702 via a signal 742 defining the amplitude set point. Apart from means to modify the amplitude 732 the circuitry further includes means to modify the phase 734 of the RF signal, wherein a further signal 744 is used to define the default phase. The RF signal is then fed into the transmission line element 106 through an impedance matching network at the input end 132, which is not shown in figure 22.

At the output end 134 of the transmission line element 106 a switch 750 allows to either to dump the RF energy into a termination 752 or to regenerate the RF energy via a feedback circuit 700. Preferably, the RF energy is dumped after each pulse of a pulse sequence. In order to combine the output and the input RF signals the feedback circuit 700 includes means to adjust the phases and amplitudes of the two RF signals. Therefore, a fraction 768 of the total input RF signal and a fraction of the output RF signal 766 are diverted to a comparator 754. In the context described herein, a fraction may be as small as 1/1000 of a signal strength. The comparator 754 transfers the information of the amplitude difference 743 to a second amplifier 758 in the feedback circuit 700 in order to adjust the amplitude of the output RF signal to a desired value, e.g. 50% of the amplitude of the desired total input RF signal. Furthermore, a second comparator 756 compares the total input signal amplitude with a reference value and produces a correction factor 746 to modify the amplitude of the signal from the signal generator 702 via the first amplifier 732, e.g. 50% of the amplitude of the desired total input RF signal.

In the next stage the phases of the input and output RF signals are adjusted by the phase shifter 762 in combination with the third comparator 760. For this purpose a fraction 772 of the input RF signal from the signal generator including amplitude and phase adjustment is diverted and compared to a diverted fraction 770 of the output RF signal. Here a fraction may be as small as 1/1000 of the signal strength. The phase shift of the output RF signal is accomplished by the phase shifter 762 via the comparator signal 748.

After the phase and the amplitude of the input RF signal and the output RF signal are matched, these signals are summed by a summing unit 764. The total RF signal fed into the transmission line element 118 is composed of regenerated RF energy as well as input energy from the signal generator 702. This way the transmission line element 118 can be operated in very energy efficient manner and the energy consumption of the system can be reduced to a minimum.

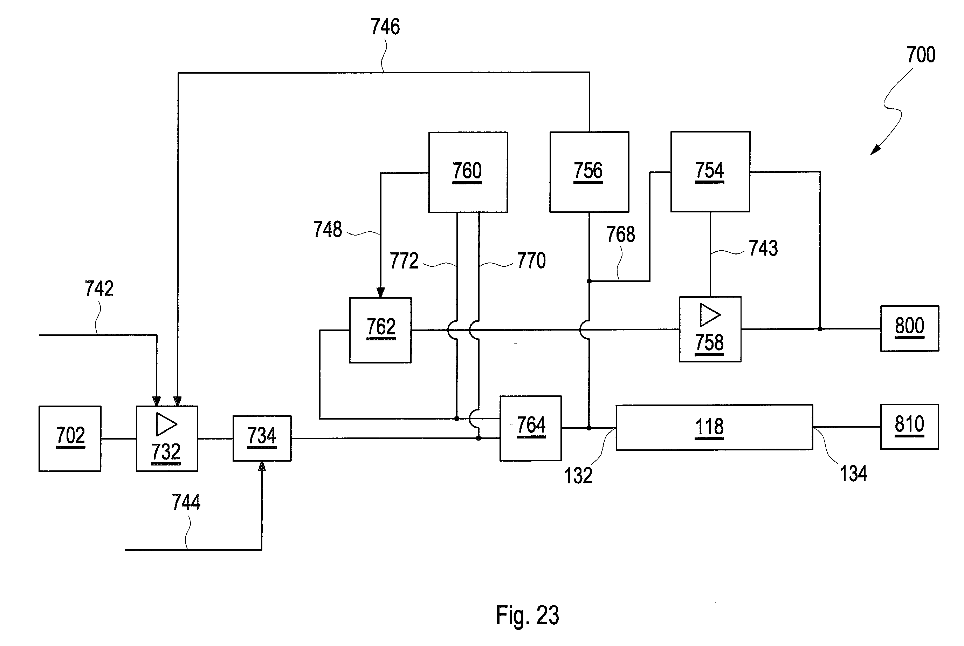

Another embodiment for energy regeneration via a feedback circuit 700 is shown in figure 23. Here the general circuitry is similar to the one shown in the previous figure including means to match the amplitudes 732, 758 and phases 734, 763 of the input and output RF signals. Furthermore impedance matching networks for coupling RF signals into the transmission line element 118 are not depicted. However, the embodiment shown in figure 23 comprises energy regeneration between different transmission line elements 118. In order to realize such a regeneration between transmission line elements 118 the output signal 810 of one transmission line element x is fed into the feedback circuit 700 of transmission line element x+1 (not shown). Furthermore, the energy regenerated from transmission line element x-1 (not shown) is fed into the feedback circuit of transmission line element x. This way a plurality of transmission line elements 118 are connected in series delivering output RF energy to the following transmission line element 118 in the circuitry and imbibing RF energy from the previous transmission line element 118 in the circuitry. The last transmission line element 118 in such a circuitry may be terminated in order to dump the RF energy.

### Reference numerals

- object to be imaged: 100
- MRI scanner: 101
- means to generate the uniform static:
- magnetic field: 102
- gradient field coils: 104
- transmission line array: 106, 106', 106"
- longitudinal length: 108, 112, 124
- diameter: 110, 114, 122
- investigation area: 116
- transmission line elements: 118
- end of the transmission line array: 132, 134
- conductive strips: 202, 204
- intermitted center: 206
- end portion: 208,210
- RF shield: 212
- dielectric medium: 214
- inner and outer ring: 220, 222
- gap: 224
- center: 600
- equipotential lines: 602
- B1 high: 604
- B1 attenuation: 608
- B1 maximum: 610
- SAR decline: 612
- SAR constant: 614
- SAR decay: 616
- SAR local minimum: 618
- Feedback circuit: 700
- signal generator/receiver: 702
- transmit receive switch: 704
- impedance matching networks: 706
- termination: 710
- coupling-in end: 712
- coupling-out end: 714
- means to detect and adjust:
- amplitude and phase: 720, 722, 732, 734
- feedback circuit: 724
- summing unit: 726
- signal flow: 742, 744, 748
- amplitude difference: 743
- correction factor: 746
- switch: 750
- termination: 752
- comparator: 754, 756, 760
- amplifier: 758
- phase shifter: 762
- summing unit: 764
- output RF signal: 766
- input RF signal: 768
- diverted fraction: 770
- longitudinal dimension: Z
- transversal axis: X/Y
- B1-field distribution: F
- SAR-distribution: S

## Claims

1. A transmission line array (106, 106', 106") for magnetic resonance imaging of an object (100) to be imaged comprising a plurality of transmission line elements (118), wherein the plurality of transmission line elements (118) are arranged in a generally cylindrical configuration having an arbitrarily chosen longitudinal (Z) length (108, 112, 124).

2. The transmission line array (106, 106', 106") according to claim 1, wherein said longitudinal (Z) length (108, 112, 124) of said generally cylindrical configuration of transmission line elements (118) depends on said object (100) to be imaged or a section of said object (100) to be imaged

3. The transmission line array (106, 106', 106") according to claims 1 or 2, wherein said plurality of transmission line elements (118) are operable to transmit and/or receive travelling-waves at variable radio-frequencies.

4. The transmission line array (106, 106', 106") according to one or more of claims 1 to 3, wherein said transmission line elements (118) comprise at least two electrical conductive strips (202, 204) along a longitudinal direction (Z) forming a gap (224) between at least one inner electrical conductive strip (202) and at least one outer electrical conductive strip (204).

5. The transmission line array (106, 106', 106") according to claim 4, wherein at least one of said at least two electrical conductive strips (202, 204) exhibits a concave or convex shape along a longitudinal direction (Z) and/or wherein at least one of said at least two electrically conductive strips (202, 204) is curved in a concave or convex manner along the longitudinal direction (Z).

6. The transmission line array (106, 106', 106") according to claims 4 or 5, wherein said plurality of transmission line elements (118) comprises a dielectric medium (214) in said gap (224) between said at least one inner electrical conductive strip (202) and said at least one outer electrical conductive strip (204).

7. The transmission line array (106, 106', 106") according to one or more of claims 1 to 6, wherein at least one end portion (208, 210) of said transmission line elements (118) is impedance matched by utilizing capacitive and/or inductive elements.

8. The transmission line array (106, 106', 106") according to one or more of claims 1 to 7, wherein a radio-frequency signal coupled into adjacent transmission line elements (118) exhibits a phase shift.

9. The transmission line array (106, 106', 106") according to one or more of claims 1 to 8, wherein said generally cylindrical configuration of transmission line elements (118) is partly or fully surrounded by an RF shield (212).

10. A magnetic resonance imaging system (101) for imaging an object (100) to be imaged, comprising a magnet assembly (102) for generating a uniform static magnetic field, a gradient coil assembly (104) for applying gradient magnetic fields to said uniform static field along selected gradient axes (X, Y, Z), means for transmitting travelling radio-frequency waves to excite nuclear spins of an object (100) to be imaged or a section of said object (100) to be imaged and/or receiving signals generated by excited nuclei of said object (100) to be imaged or said section of said object (100) to be imaged, wherein said means for transmitting and/or receiving travelling radio-frequency waves comprise the transmission line array (106, 106', 106") of one or more of claims 1 to 9.

11. A method for creating a radio-frequency excitation field for magnetic resonance imaging using a transmission line array (106, 106', 106") comprising transmission line elements (118) in a generally cylindrical configuration, wherein the method includes the steps:
a) positioning said transmission line array (106, 106', 106") having an arbitrarily chosen longitudinal (Z) length (108, 112, 124) around an object (100) to be imaged or selectively around a section of said object (100) to be imaged,
b) coupling-in a radio-frequency signal to said transmission line array (106, 106', 106"),
c) transmitting and/or receiving travelling radio-frequency waves through said transmission line array (106, 106', 106").

12. The method according to claim 11, wherein said longitudinal length (108, 112, 124) of said transmission line array (106, 106', 106") depends on said object (100) to be imaged or said section of said object (100) to be imaged.

13. The method according to claims 11 or 12, wherein said transmission line array (106, 106', 106") is positioned locally around a section of said object (100) to be imaged.

14. The method according to one or more of claims 11 to 13, wherein the travelling-waves are transmitted and/or received at variable radio-frequencies.

15. The method according to one or more of claims 11 to 14, wherein said transmission line array (106, 106', 106") is connected to a transceiver circuit for coupling travelling radio-frequency waves into transmission line array (106, 106', 106"), wherein said transceiver circuit controls a plurality of transmission line elements (118) of said transmission line array (106, 106', 106") individually.

16. The method according to claim 15, wherein said transceiver circuit comprises a plurality of phase shifters, adjusting the phase of said travelling radio-frequency waves coupled into said transmission line elements (118), individually for each channel, and means to adjust the amplitude of said travelling radio-frequency waves coupled into said transmission line elements (118), individually for each channel.

17. The method according to one or more of claims 11 to 16, wherein said radio-frequency waves are coupled into said transmission line array (106, 106', 106") at an input end (712) of said transmission line array (106, 106', 106") and coupled out at an output end (714) of said transmission line array (106, 106', 106"), wherein said travelling radio-frequency waves are dissipated at a dissipating termination or said travelling radio-frequency waves are fed back to said input end by a feedback circuit (724).
